(19) Europäisches Patentamt
European Patent Office
Office européen des brevets

(11) **EP 3 955 335 B1**

(12) **EUROPEAN PATENT SPECIFICATION**

(45) Date of publication and mention
of the grant of the patent:
**22.04.2026   Bulletin 2026/17**

(21) Application number: **20814704.1**

(22) Date of filing: **29.05.2020**

(51) International Patent Classification (IPC):
*H01M 4/13* (2010.01)    *H01M 4/62* (2006.01)
*H01M 10/052* (2010.01)    *H01M 4/139* (2010.01)
*H01M 4/04* (2006.01)    *C23C 16/40* (2006.01)
*C23C 16/455* (2006.01)    *F16K 7/00* (2006.01)
*H01M 4/131* (2010.01)    *H01M 4/1391* (2010.01)
*H01M 4/36* (2006.01)    *H01M 4/525* (2010.01)
*C23C 16/04* (2006.01)    *H01M 4/02* (2006.01)

(52) Cooperative Patent Classification (CPC):
**H01M 4/131; C23C 16/045; C23C 16/40;**
**C23C 16/45555; H01M 4/0421; H01M 4/1391;**
**H01M 4/362; H01M 4/525; H01M 4/62;**
H01M 10/052; H01M 2004/028; Y02E 60/10

(86) International application number:
**PCT/KR2020/007051**

(87) International publication number:
**WO 2020/242266 (03.12.2020 Gazette 2020/49)**

(54) **POSITIVE ELECTRODE FOR LITHIUM SECONDARY BATTERY AND LITHIUM SECONDARY BATTERY HAVING THE SAME**

POSITIVELEKTRODE FÜR LITHIUMSEKUNDÄRBATTERIE UND LITHIUMSEKUNDÄRBATTERIE DAMIT

ÉLECTRODE POSITIVE POUR BATTERIE RECHARGEABLE AU LITHIUM ET BATTERIE RECHARGEABLE AU LITHIUM COMPRENANT CELLE-CI

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority:   **31.05.2019   KR 20190064862**

(43) Date of publication of application:
**16.02.2022   Bulletin 2022/07**

(73) Proprietor: **LG Energy Solution, Ltd.**
**Seoul 07335 (KR)**

(72) Inventors:
• **LEE, Eun-Jeong**
**Daejeon 34122 (KR)**
• **KIM, Ki-Hwan**
**Daejeon 34122 (KR)**
• **KIM, Yong-Chan**
**Daejeon 34122 (KR)**
• **KIM, In-Chul**
**Daejeon 34122 (KR)**
• **PARK, Sang-Joon**
**Daejeon 34122 (KR)**

(74) Representative: **Hoffmann Eitle**
**Patent- und Rechtsanwälte PartmbB**
**Arabellastraße 30**
**81925 München (DE)**

(56) References cited:
KR-A- 20090 076 277    KR-A- 20130 014 245
KR-A- 20160 005 999    KR-A- 20160 126 840
KR-A- 20170 063 141    KR-A- 20170 118 480
US-A1- 2012 077 082    US-A1- 2016 172 682
US-A1- 2018 108 908

EP 3 955 335 B1

**Description**

TECHNICAL FIELD

The present disclosure relates to a positive electrode for a lithium secondary battery and a lithium secondary battery having the same. More particularly, the present disclosure relates to a positive electrode for a lithium secondary battery with improved cycle characteristics and storage stability and a lithium secondary battery having the same.

The present application claims the benefit of Korean Application No. 10-2019-0064862 filed on May 31, 2019 with the Korean Intellectual Property Office.

BACKGROUND ART

Recently, there has been dramatically growing interest in energy storage technology. As the application field of energy storage technology has been extended to mobile phones, camcorders, laptop computers, and even electric vehicles, there is the increasing demand for high energy density of batteries used as power sources for electronic devices. Lithium secondary batteries meet the demand best, and many studies are currently made on them.

In currently available secondary batteries, lithium secondary batteries developed in the early 1990s includes a negative electrode of a carbon material capable of intercalating and deintercalating lithium ions, a positive electrode of lithium-containing oxide and a non-aqueous electrolyte containing an optimum amount of lithium salts dissolved in a mixed organic solvent.

In this instance, the positive electrode suffers severe electrolyte decomposition on the surface due to the high oxidation potential, causing gas generation and consequential cell swelling. **In** addition, during intercalation and deintercalation of lithium ions, the structure becomes unstable and metal deposition on the electrode occurs, which degrades the battery. This phenomenon is more severe and faster, especially in high-energy active materials, and it reduces the capacity retention of the battery and may pose a threat to safety.

To improve the electrode stability and safety of the lithium secondary battery, surface coating via vapor deposition or sputtering has been proposed, but this coating method is difficult to achieve deep penetration into the electrode to form a coating layer on the surface of the inside of the pores.

Atomic layer deposition is a technique that injects precursors and reactants in a time division manner using gas phase chemical vapor deposition reaction to suppress the gas phase reaction and accurately control the thickness of the thin film through self-control reaction on the surface of the substrate.

The coating using atomic layer deposition may be largely classified into two: coating an active material at the particle level; and coating an active material slurry on an electrode and drying, and coating on the formed electrode.

**In** the case of atomic layer deposition on the active material particles, a coating layer formed on the particle surface may act as an insulating layer that restricts the electron movement. **In** contrast, electrode coating does not interrupt the existing conductive path, and thus does not hinder the movement of electrons, thereby minimizing the increase in cell resistance.

However, the general atomic layer deposition process is an atomic layer deposition process best suited for a flat plate, so when the general atomic layer deposition process is applied to the active material layer of the electrode, it is difficult to form an atomic layer deposition layer over the entire active material layer to the deepest region of the active material layer of the electrode, i.e., the region in contact with the current collector. **In** most of patents or papers, atomic layer deposition is applied to electrodes having relatively high porosity (void fraction), and in this case, atomic layer deposition is well performed up to deep inside the electrode active material layer, and thus the distribution of the atomic layer deposition layer in the depth-wise direction of the active material layer has never been considered before.

Actually, the electrode applied to the battery has very low porosity since it is pressed under high pressure after coating of the active material layer on the current collector, and thus it is still difficult to perform atomic layer deposition on the active material layer of the electrode having low porosity in the thickness-wise direction up to the area near the current collector. **In** addition, the electrode produced by the general atomic layer deposition process has an atomic layer deposition layer formed only near the surface, and thus has the limited effect.

US 2012/0077082 A1 describes electrodes for lithium batteries coated via an atomic layer deposition process.

US 2018/0108908 A1 concerns a coated electrode comprising a cathode active composition that includes a polymer binder, electrically conductive carbon additive and a lithium rich metal oxide.

US 2016/0172682 A1 describes a method of manufacturing a secondary battery electrode including the steps of depositing an ink including at least one active electrode material on a substrate, drying the ink, depositing a protection layer on the previously dried ink and calendaring the electrode thus formed.

Accordingly, there is still a very high need for positive electrode technology for improving the performance of secondary batteries.

## DISCLOSURE

### Technical Problem

The present disclosure is directed to providing a positive electrode for a lithium secondary battery with high storage stability for long-term storage and improved battery life, and a lithium secondary battery having the same.

### Technical Solution

To solve the above-described problem, according to an aspect of the present disclosure, there is provided a positive electrode for a lithium secondary battery of the following embodiments.

A first embodiment relates to the positive electrode for a lithium secondary battery comprising a current collector, and a positive electrode active material layer comprising a plurality of positive electrode active materials disposed at least one surface of the current collector and an atomic layer deposition (ALD) coating layer disposed in surfaces and pores of the positive electrode active materials and gaps between the plurality of positive electrode active materials, wherein the positive electrode active materials include a lithium cobalt-nickel-manganese oxide, and the atomic layer deposition coating layer comprises $AlO_x$, wherein x is greater than 0 and 3 or smaller, wherein the atomic layer deposition coating layer is 0.2 to 1 nm in thickness, when the positive electrode active material layer is equally divided into five in a thickness-wise direction, the portion of the positive electrode active material layer in contact with the current collector is referred to as the lowermost positive electrode active material layer and the surface portion of the positive electrode active material layer farthest away from the current collector is referred to as the uppermost positive electrode active material layer, the amount of the atomic layer deposition coating layer of the lowermost positive electrode active material layer is 40 weight% or more relative to the amount of the atomic layer deposition coating layer of the uppermost positive electrode active material layer, and the positive electrode has a porosity of 15 to 35%, and wherein the positive electrode is obtainable by forming an atomic layer deposition coating layer on the pressed positive electrode.

According to a second embodiment, the porosity of the positive electrode may be 20 to 30%.

According to a third embodiment, in the first or second embodiments, the atomic layer deposition coating layer may be 0.2 to 1 nm in thickness.

According to a fourth embodiment, in any one of the first to third embodiments, the amount of the atomic layer deposition coating layer of the lowermost positive electrode active material layer may be 40 weight% to 120 weight% relative to the amount of the atomic layer deposition coating layer of the uppermost positive electrode active material layer.

According to an fifth embodiment, in any one of the first to fourth embodiments, the amount of the atomic layer deposition coating layer may be 300 ppm to 6,000 ppm based on the weight of the positive electrode active material layer.

To solve the above-described problem, according to an aspect of the present disclosure, there is provided a lithium secondary battery of the following embodiment.

According to a sixth embodiment, the lithium secondary battery comprises an electrode assembly comprising a positive electrode, a negative electrode and a separator interposed between the positive electrode and the negative electrode, a battery case in which the electrode assembly is received, and a non-aqueous electrolyte solution injected into the battery case, wherein the positive electrode may be the positive electrode for a lithium secondary battery according to any one of the first to eighth embodiments.

### Advantageous Effects

The positive electrode for a lithium secondary battery according to an embodiment of the present invention has an atomic layer deposition coating layer, which is thinner than a conventional atomic layer deposition coating layer, formed up to deep inside the current collector direction of the positive electrode active material layer, and the atomic layer deposition coating functions as a protective layer over the entire thickness of the positive electrode active material layer, thereby suppressing the degradation of the positive electrode and improving stability. The lithium secondary battery having the positive electrode maintains the capacity retention in repeated cycles and exhibits long life characteristics, and when stored at high temperature in a fully charged state, the atomic layer deposition coating layer contributes to the stabilization of the positive electrode active material in unstable structural state during lithium ion intercalation, thereby minimizing the increase in battery resistance after long-term storage, resulting in improved storage stability.

### BRIEF DESCRIPTION OF DRAWINGS

The accompanying drawings illustrate a preferred embodiment of the present disclosure, and together with the detailed disclosure, serve to provide a further understanding of the technical aspects of the present disclosure, and the present disclosure should not be construed as being limiting to the drawings.

FIG. 1 is a scanning electron microscopy (SEM) image of a cross section of a positive electrode having an atomic layer deposition coating layer prepared according to Example 3 of the present disclosure.

FIG. 2 is an elemental mapping image of aluminum measured through Energy Dispersive X-ray Spectroscopy of a cross section of a positive electrode having an atomic layer deposition coating layer prepared according to Example 3 of the present disclosure.

FIG. 3 is a diagram showing five equal divisions of a cross section of a positive electrode active material layer according to Experimental Example 2 of the present disclosure.

FIG. 4 is a graph showing charge and discharge cycles according to Experimental Example 3 of the present disclosure.

FIG. 5 is a graph showing resistance increase vs storage period for storage stability evaluation according to Experimental Example 4 of the present disclosure.

BEST MODE

Hereinafter, the present disclosure will be described in detail with reference to the accompanying drawings. It should be understood that the terms or words used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

A positive electrode for a lithium secondary battery according to an aspect of the present disclosure comprises:

a current collector; and
a positive electrode active material layer having a plurality of positive electrode active materials disposed on at least one surface of the current collector and an atomic layer deposition (ALD) coating layer disposed in the surfaces and pores of the positive electrode active material and gaps between the plurality of positive electrode active materials, wherein the positive electrode active materials include a lithium cobalt-nickel-manganese oxide, and the atomic layer deposition coating layer comprises $AlO_x$, wherein x is greater than 0 and 3 or smaller,
wherein the atomic layer deposition coating layer has a thickness of 0.2 to 1 nm,
when the positive electrode active material layer is equally divided into five in the thickness-wise direction, the portion of the positive electrode active material layer in contact with the current collector is referred to as the lowermost positive electrode active material layer, and the surface portion of the positive electrode active material layer farthest away from the current collector is referred to as the uppermost positive electrode active material layer, the amount of the atomic layer deposition coating layer of the lowermost positive electrode active material layer is 40 weight% or more relative to the amount of the atomic layer deposition coating layer of the uppermost positive electrode active material layer, and
the positive electrode has a porosity of 15% to 35%,
wherein the positive electrode is obtainable by forming an atomic layer deposition coating layer on the pressed positive electrode.

The current collector is not limited to a particular type if it has high conductivity without causing a chemical change in the lithium secondary battery, and may include, for example, stainless steel, aluminum, nickel, titanium, calcined carbon, or aluminum or stainless steel surface treated with carbon, nickel, titanium and silver.

The current collector may increase the adhesive strength of the positive electrode active material by forming fine texture on its surface, and may come in various forms such as a film, a sheet, a foil, a net, a porous body, a foam, and a nonwoven fabric.

The current collector may have a thickness of 3 to 500 $\mu$m, and specifically 5 to 50 $\mu$m.

In an embodiment of the present disclosure, the positive electrode active material layer may include a positive electrode active material, a binder polymer and a conductive material.

The positive electrode active material is a lithium-containing transition metal oxide, and includes lithium cobalt-nickel-manganese oxide, lithium cobalt-nickel-manganese-aluminum oxide,.

According to an embodiment of the present disclosure, the lithium-containing transition metal oxide may include at least one of $Li_x(Ni_aCo_bMn_c)O_2$ (0.5<x<1.3, 0<a<1, 0<b<1, 0<c<1, a+b+c=1), $Li_x(Ni_aCo_bMn_cAl_d)O_2$ (0.5<x<1.3, 0<a<1, 0<b<1, 0<c<1, 0<d<1, a+b+c+d=1), $Li_x(Ni_aCo_bMn_c)O_4$ (0.5<x<1.3, 0<a<2, 0<b<2, 0<c<2, a+b+c=2), , and the lithium-containing transition metal oxide may be coated or doped with metal such as boron (B), aluminum (Al) and zirconium (Zr) or metal oxide. In addition to the lithium-containing transition metal oxide, sulfide, selenide and halide may be used.

The binder polymer may include at least one selected from the group consisting of vinylidene fluoride-hexafluoropropylene copolymer (PVDF-co-HFP), polyvinylidenefluoride, polyacrylonitrile, polymethylmethacrylate, polyvinyl alcohol, carboxymethyl cellulose (CMC), starch, hydroxypropyl cellulose, regenerated cellulose, polyvinylpyrrolidone, tetrafluoroethylene, polyethylene, polypropylene, polyacrylic acid, ethylene-propylene-diene monomer (EPDM), sulfonated EPDM, styrene butylene rubber (SBR) and fluorine rubber.

The conductive material generally includes conductive carbon, and may include, for example, various types of conductive carbon materials such as graphite, carbon black, acetylene black, ketjen black, super-P and carbon nanotubes.

In the positive electrode active material layer, the binder polymer may be present in an amount of 0.1 to 10 parts by weight or 1 to 5 parts by weight, the conductive material may be present in an amount of 0.5 to 10 parts by weight or 1 to 5 parts by weight, based on 100 parts by weight of the positive electrode active material. When the amounts of the binder polymer and the conductive material satisfy the above-described range, the positive electrode active material is included in a sufficient amount, and as a result, the capacity does not reduce, it is advantageous for the electrode process, and the life performance may be improved.

The positive electrode active material layer may be formed on one or two surfaces of the current collector, and the thickness of the positive electrode active material layer formed on one surface of the current collector may be 20 to 200 $\mu$m, specifically 30 to 150 $\mu$m, and more specifically 50 to 150 $\mu$m.

The positive electrode includes the atomic layer deposition coating layer disposed in the surface and pores of the positive electrode active material layer.

The thickness of the atomic layer deposition coating layer is 0.2 to 1 nm, or 0.2 to 0.8 nm, or 0.24 to 0.8 nm, or 0.24 to 0.55 nm. When the thickness of the atomic layer deposition coating layer satisfies the above-described range, the resistance of the battery hardly increases and the atomic layer deposition coating layer may sufficiently function as a protective layer for the positive electrode active material layer. Specifically, in case that the thickness of the atomic layer deposition coating layer fails to satisfy the above-described range, when the thickness is lower than 0.2 nm, the atomic layer deposition coating layer cannot sufficiently function as a protective layer, and when the thickness is larger than 1 nm, the resistance at the interface between the positive electrode active material layer and the electrolyte rapidly increases, the resistance of the battery increases, and the output characteristics decrease. In addition, when the atomic layer deposition coating layer is not formed up to the positive electrode active material layer adjacent to the current collector, the function as a protective layer is weakened, and in particular, the performance of retarding the battery degradation may reduce with the increasing charge/discharge cycles or during long-term storage.

The atomic layer deposition is performed by injecting a precursor of a deposition material on the surface of the positive electrode active material layer, injecting water vapor and injecting an inert gas between each step, and the thickness of the atomic layer deposition coating layer may be adjusted by controlling the number of cycles of the series of processes. Here, the thickness of the atomic layer deposition coating layer refers to a thickness formed by atomic layer deposition performed on a silicon wafer under the same conditions as the atomic layer deposition performed on the positive electrode active material layer as defined above.

The thickness of the atomic layer deposition coating layer disposed in the surface and pores of the positive electrode active material layer is defined as a thickness formed by atomic layer deposition performed on a silicon wafer under the same conditions as the atomic layer deposition performed on the positive electrode active material layer. The thickness of the atomic layer deposition coating layer may be measured by fitting 380 nm to 780 nm measured with a spectroscopic ellipsometer using a Modified Cauchy model.

The atomic layer deposition coating layer is formed in the surface and pores of the positive electrode active material layer, and the pore size of the positive electrode active material layer has a small size ranging from a few micrometers to a few hundreds of nanometers, even to a few tens of nanometers, and connection between them is not smooth. Accordingly, it is very difficult to form a uniform atomic layer deposition coating layer over the entire positive electrode active material layer from the surface of the positive electrode active material layer to the current collector, and accordingly, the atomic layer deposition coating layer is formed with the largest thickness in the uppermost positive electrode active material layer, and is formed with the smallest thickness in the lowermost positive electrode active material layer toward the current collector.

Accordingly, the ratio of the amount of the atomic layer deposition coating layer of the lowermost positive electrode active material layer to the amount of the atomic layer deposition coating layer of the uppermost positive electrode active material layer indicates how much the atomic layer deposition coating layer is uniformly formed in the thickness-wise direction of the positive electrode active material layer.

The inventors found that the distribution of the atomic layer deposition coating layer greatly affects the performance of the battery, and accordingly, they took notice of the ratio of the amount of the atomic layer deposition coating layer of the lowermost positive electrode active material layer to the amount of the atomic layer deposition coating layer of the uppermost positive electrode active material layer.

In the present disclosure, when the positive electrode active material layer is equally divided into five in the thickness-wise direction, the portion of the positive electrode active material layer in contact with the current collector is referred to as the lowest positive electrode active material layer, and the surface portion of the positive electrode active material layer farthest away from the current collector is referred to as the uppermost positive electrode active material, the distribution uniformity of the atomic layer deposition coating layer is defined as the ratio (weight%) of the amount of the atomic layer deposition coating layer of the lowermost positive electrode active material layer to the amount of the atomic layer deposition coating layer of the uppermost positive electrode active material layer.

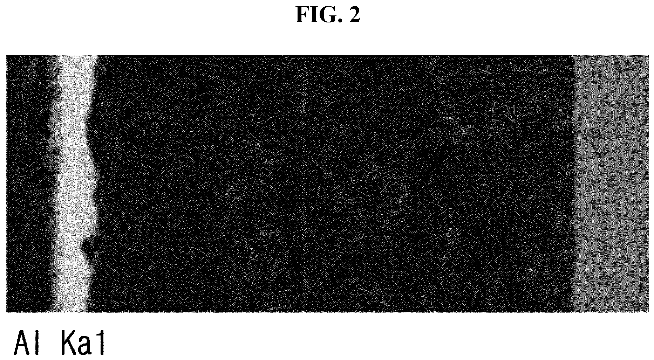

For example, when the positive electrode active material layer is equally divided into five in the thickness-wise direction, the five equal divisions may be referred to as a first positive electrode active material layer, a second positive electrode active material layer, a third positive electrode active material layer, a fourth positive electrode active material layer and a fifth positive electrode active material layer in an order of from the surface portion of the positive electrode active material layer farthest away from the current collector to the positive electrode active material layer portion in contact with the current collector. In this instance, the first positive electrode active material layer may correspond to the uppermost positive electrode active material layer, and the fifth positive electrode active material layer may correspond to the lowermost positive electrode active material layer. The cross-sectional electron micrographic image of the positive electrode active material layer partitioned into the first positive electrode active material layer to the fifth positive electrode active material layer is shown in FIG. 2.

The inventors repeatedly verified a gradual change of the distribution of the atomic layer deposition coating layer from the surface to the current collector. As a result, in the present disclosure, in evaluating the distribution uniformity of the atomic layer deposition coating layer, the positive electrode active material layer is equally divided into five in the thickness-wise direction, and the distribution uniformity is defined as the ratio (weight%) of the amount of the atomic layer deposition coating layer of the lowermost positive electrode active material layer (the first active material layer) to the amount of the atomic layer deposition coating layer of the uppermost positive electrode active material layer (the fifth active material layer). Generally, the distribution uniformity of the atomic layer deposition coating layer is evaluated by equally dividing the positive electrode active material layer into five in the thickness-wise direction for the following reason: when the atomic layer deposition coating layer is equally divided into less than five, it does not make difference to the determination of the uniformity of the distribution, and when the positive electrode active material layer is equally divided into more than five, the average particle diameter of the positive electrode active material particles included in the positive electrode active material layer is larger than the height of one division of the positive electrode active material layer, and thus there is a very large difference in the distribution of the atomic layer deposition coating layer and the reproducibility of distribution evaluation is notably reduced.

The general atomic layer deposition process cannot form atomic layer deposition on the active material layer of the electrode having low porosity to a region near the current collector in the thickness-wise direction. Accordingly, the inventors improve the depth-wise direction distribution of the atomic layer deposition coating layer by controlling various parameters of the atomic layer deposition process. To this end, the controllable atomic layer deposition process parameters largely includes the heating temperature of the substrate, the injection amount and concentration of the precursor and the reactive gas, the exposure time of the precursor and the reactive gas to the substrate, the flow rate of the precursor, the reactive gas, the carrier gas and the purge gas, the injection time of the purge gas and the process pressure. The higher the heating temperature of the substrate, the smoother the atomic layer deposition into the pores of the substrate may be made, but the heating temperature of the substrate is adjusted while considering the heat resistance temperature of the substrate. For example, in the positive electrode according to the embodiment of the present disclosure, the heating temperature of the substrate is preferably 120°C to 150°C. It is necessary to supply a sufficient injection amount of the precursor and the reactive gas relative to the specific surface area of the substrate. For example, the number of trimethylaluminum molecules required per unit area at each time of atomic layer deposition may be calculated from the density of aluminum oxide formed as a film in the atomic layer deposition of aluminum oxide and the thickness formed at each time of atomic layer deposition. It is necessary to supply the injection amount at a sufficient ratio relative to the specific surface area of the substrate. Here, the sufficient ratio is at least twice, preferably 10 times or more. In addition, to obtain such a sufficient injection amount, the vapor pressure may be adjusted by adjusting the temperature of a container for supplying the precursor and the reactive gas, and the injection time may be adjusted. It is not desirable that the concentration of the precursor and the reactive gas is too low, and the concentration of the precursor and the reactive gas is determined by a ratio of the injection amount adjusted by the temperature and the injection time, and the carrier gas. The exposure time of the precursor and the reactive gas is related to the reaction rate, and it is important to obtain sufficient time for the precursor and the reactive gas to permeate deep in the pores of the substrate having a complex pore shape such as the positive electrode. It usually takes more time for the gas to penetrate the pores than the reaction rate. The exposure time may be shortened by increasing the temperature of the substrate. The flow rate of the precursor, the reactive gas, the carrier gas and the purge gas greatly affects the depth-wise direction deposition distribution of the positive electrode substrate. As the process pressure is higher, it is more favorable to deposit the inside of the substrate pores, but when the process pressure is too high, atomic layer deposition is not properly performed and powder may be formed by gas phase reaction.

In the present disclosure, the ratio of the amount of the atomic layer deposition coating layer of the lowermost positive electrode active material layer to the amount of the atomic layer deposition coating layer of the uppermost positive electrode active material layer is 40 weight% or more. According to an embodiment of the present disclosure, the ratio of the amount of the atomic layer deposition coating layer of the lowermost positive electrode active material layer to the amount of the atomic layer deposition coating layer of the uppermost positive electrode active material layer may be 40 weight% to 120 weight%, or 49 weight% to 107 weight%, or 50 to 100 weight%.

When the ratio of the amount of the atomic layer deposition coating layer of the lowermost positive electrode active material layer to the amount of the atomic layer deposition coating layer of the uppermost positive electrode active material layer satisfies the above-described range, the atomic layer deposition coating layer is uniformly formed from the surface of the positive electrode active material layer to the bottom in contact with the current collector, and it functions as a protective layer over the entire thickness of the positive electrode active material layer, thereby maintaining the protection function of the atomic layer deposition coating layer for the positive electrode active material layer without deterioration in a few hundreds of repeated charge and discharge cycles, stably maintaining the capacity during high temperature storage, and suppressing the increase in resistance.

**In** this instance, the positive electrode active material layer is equally divided into five in the thickness-wise direction, and the amount of the atomic layer deposition coating layer in each of the first positive electrode active material layer, the second positive electrode active material layer, the third positive electrode active material layer, the fourth positive electrode active material layer, and the fifth positive electrode active material layer in an order from the surface portion of the positive electrode active material layer farthest away from the current collector to the positive electrode active material layer portion in contact with the current collector may be measured by quantifying the elements included in the atomic layer deposition coating layer through energy dispersive X-ray spectroscopy of an electron microscope after cutting the positive electrode active material layer having the atomic layer deposition coating layer in a direction perpendicular to the current collector. Alternatively, a ratio of an amount of a specific element included in the atomic layer deposition coating layer, for example, aluminum (Al), to an amount of a specific element of the positive electrode active material layer, for example, nickel (Ni), may be calculated through a value measured through the above-described method to see if atomic layer deposition coating is uniformly formed in the thickness-wise direction of the active material.

The amount of the metal element in the atomic layer deposition coating layer may be 300 ppm to 6,000 ppm, or 300 ppm to 4,000 ppm, or 400 ppm to 2,000 ppm, based on the total weight of the positive electrode active material layer having the atomic layer deposition coating layer. **In** this instance, the positive electrode active material layer refers to all layer components formed on the current collector, including the positive electrode active material, the conductive material, the binder polymer and the atomic layer deposition coating layer of the positive electrode.

When the amount of the atomic layer deposition coating layer satisfies the above-described range, it is possible to minimize an increase in resistance of the battery without losing the function as a protective layer for the positive electrode active material layer, and prevent the problems that occur when the amount of the atomic layer deposition coating layer is too large, such as low energy density of the battery, an increase in resistance and a reduction in the output characteristics.

The atomic layer deposition coating layer may include at least one of oxide, nitride, oxynitride, sulfide, fluoride or phosphate of metal or metalloid, and in this instance, the metal or metalloid may include at least one of Al, Zr, Si, Zn, Ti, Sn, Mn, Nb, W or Li.

In addition, according to an embodiment of the present disclosure, the atomic layer deposition coating layer comprises $AlO_x$, and in this instance, x is greater than 0 and 3 or smaller.

The porosity of the positive electrode (the porosity of the positive electrode including the positive electrode active material layer and the atomic layer deposition coating layer disposed in the surface and pores of the positive electrode active material layer) is 15% to 35%, or according to an embodiment of the present disclosure, the porosity may be 20% to 30%.

In addition, the porosity of the positive electrode active material layer before forming the atomic layer deposition coating layer is 15% to 35%, or according to an embodiment of the present disclosure, the porosity may be 20% to 30%. The porosity of the positive electrode may be calculated by the following method.

(1) The thickness and weight per unit area of the positive electrode are measured.
(2) The density of the positive electrode (the positive electrode active material layer) including the pores is calculated by dividing the measured weight per unit area by the volume obtained by multiplying the measured thickness by the unit area.
(3) The theoretical density is calculated by multiplying the distribution amount per unit area of the constituent components of the positive electrode (the positive electrode active material, the conductive material, the binder polymer, or in the case of atomic layer deposition, the atomic layer deposition coating layer) by each known true density value.
(4) The porosity is calculated by the following equation.

Porosity (%) = [(Theoretical density calculated from (3))/(Measured density calculated from (2))-1] X 100

In addition, the porosity of the positive electrode may be measured based on how much a non-reactive liquid not absorbed into the constituent components of the positive electrode is injected into the positive electrode.

The method for manufacturing the positive electrode according to an embodiment of the present disclosure is as follows.

First, a positive electrode active material layer composition containing a positive electrode active material, a binder polymer, a conductive material and a solvent is prepared, applied on at least one surface of a current collector, dried and pressed through a roll press to form a positive electrode active material layer.

A solvent used in the present disclosure may include, but is not limited to, solvents commonly used in the art, for example, N-methylpyrrolidone (NMP).

Subsequently, an atomic layer deposition coating layer is formed in the surface and pores of the positive electrode active material layer to obtain a positive electrode active material layer.

According to an embodiment of the present disclosure, the step of forming the atomic layer deposition coating layer may include mounting a current collector (a positive electrode substrate) having the positive electrode active material layer prepared previously on an atomic layer deposition system, injecting a metal precursor into the system; purging using an inert gas (for example, Ar), supplying water vapor to substitute the binding groups of the metal precursor with OH groups; and purging using an inert gas to remove impurities and unreacted components from the system to form an atomic layer deposition coating layer.

According to an embodiment of the present disclosure, the methyl groups of the metal precursor may be substituted with hydroxyl groups in the step of injecting water vapor ($H_2O$) into the metal precursor. The step of purging using an inert gas may be performed to remove the remaining water vapor after substituting all the methyl groups of the precursor of the oxide with the hydroxyl groups.

The metal precursor may include, but is not limited to, at least one of tetramethylzirconium $[Zr(CH_3)_4]$, tetrakis(ethylmethylamido)zirconium $[Zr[N(CH_3)(CH_2CH_3)]_4$ (TEMAZ)]), zirconium tertiary-butoxide $(Zr(t-OC_4H_9)_4$, (ZTB)], trimethylaluminum $[Al(CH_3)_3$, (TMA)], tetramethylsilicon $[Si(CH_3)_4])$, dimethylzinc $[Zn(CH_3)_2])$, diethylzinc $[Zn(C_2H_5)_2$, (DEZn)]), tetramethyl titanium $[Ti(CH_3)_4])$, tetramethyltin $(Sn(CH_3)_4])$ or bis(ethylcyclopentadienyl) manganese $[Mn(CpEt)_2])$.

The inert gas may include, but is not limited to, He, $N_2$, Ne, Ar and Kr.

In forming the atomic layer deposition coating layer in the surface and pores of the positive electrode active material layer, the method of manufacturing a positive electrode may be performed by applying and drying the positive electrode active material composition, performing an atomic layer deposition coating process, and performing a pressing process to sufficiently form the atomic layer deposition coating layer from the surface portion of the positive electrode active material layer farthest away from the current collector to the positive electrode active material layer portion in contact with the current collector. Through this method, the atomic layer deposition coating layer may be formed up to the positive electrode active material layer portion in surface contact with the current collector at the maximum pore size and porosity of the positive electrode active material layer. Alternatively, when performing the atomic layer deposition coating on the pressed positive electrode, the process pressure may be increased or may be applied above the normal pressure, and the incubation time may be added to allow the metal precursor and water vapor or the inert gas to reach deep in the pores. The incubation time may be adjusted according to the porosity and thickness of the electrode.

The positive electrode for a lithium secondary battery of the present invention as described above forms an electrode assembly together with a negative electrode and a separator interposed between the positive electrode and the negative electrode, and the electrode assembly is received in a battery case, and a non-aqueous electrolyte is injected into the battery case to manufacture a lithium secondary battery. The negative electrode and the separator forming the electrode assembly together with the positive electrode according to the present disclosure, and the non-aqueous electrolyte may include those that are commonly used to manufacture lithium secondary batteries.

In the same way as the positive electrode, the negative electrode according to the present disclosure may be manufactured by mixing and stirring a negative electrode active material, a binder polymer, a solvent, and if necessary, a conductive material and a dispersing agent to prepare a slurry and applying the slurry to a current collector and drying.

The negative electrode active material may generally include a carbon material, lithium metal, silicon or tin, capable of intercalating and deintercalating lithium ions, and may include metal oxide whose potential versus lithium is less than 2V, for example, $TiO_2$ and $SnO_2$. The negative electrode active material preferably includes a carbon material, and the carbon material may include low crystalline carbon and high crystalline carbon. The low crystalline carbon may typically include soft carbon and hard carbon, and the high crystalline carbon may typically include high temperature sintered carbon such as natural graphite, artificial graphite, Kish graphite, pyrolytic carbon, mesophase pitch based carbon fibers, meso-carbon microbeads, mesophase pitches, petroleum derived cokes and tar pitch derived cokes.

The binder polymer, the solvent and the conductive material of the negative electrode may be the same as those used in the manufacture of the positive electrode.

The separator may include a porous polymer film commonly used as separators, for example, a porous polymer film made of polyolefin based polymer such as ethylene homopolymer, propylene homopolymer, ethylene/butene copolymer, ethylene/hexene copolymer and ethylene/methacrylate copolymer, used alone or in combination, or may include, but is not limited to, a general porous nonwoven fabric, for example, a nonwoven fabric made of high melting point glass fibers, polyethylene terephthalate fibers, etc.

According to an embodiment of the present disclosure, the separator may comprise the porous substrate such as a porous polymer film and a porous non-woven fabric alone, and in addition to the porous substrate, the separator may further comprise a porous coating layer comprising inorganic particles and a binder polymer on at least one surface of the porous substrate.

In the electrolyte solution used in the present disclosure, an electrolyte may include a lithium salt, and the lithium salt may include, without limitation, those commonly used in electrolytes for lithium secondary batteries, and for example, the anion of the lithium salt may include any one selected from the group consisting of $F^-$, $Cl^-$, $Br^-$, $I^-$, $NO_3^-$, $N(CN)_2^-$, $BF_4^-$, $ClO_4^-$, $PF_6^-$, $(CF_3)_2PF_4^-$, $(CF_3)_3PF_3^-$, $(CF_3)_4PF_2^-$, $(CF_3)_5PF^-$, $(CF_3)_6P^-$, $CF_3SO_3^-$, $CF_3CF_2SO_3^-$, $(CF_3SO_2)_2N^-$, $(FSO_2)_2N^-$, $CF_3CF_2(CF_3)_2CO^-$, $(CF_3SO_2)_2CH^-$, $(SF_5)_3C^-$, $(CF_3SO_2)_3C^-$, $CF_3(CF_2)_7SO_3^-$, $CF_3CO_2^-$, $CH_3CO_2^-$, $SCN^-$ and $(CF_3CF_2SO_2)_2N^-$.

In the electrolytic solution used in the present disclosure, an organic solvent included in the electrolytic solution may include, without limitation, those commonly used in electrolytes for lithium secondary batteries, and may typically include at least one selected from the group consisting of propylene carbonate (PC), ethylene carbonate (EC), diethyl carbonate (DEC), dimethyl carbonate (DMC), ethylmethyl carbonate (EMC), methylpropyl carbonate, dipropyl carbonate, dimethylsulfoxide, acetonitrile, dimethoxyethane, diethoxyethane, vinylene carbonate, sulfolane, gamma-butyrolactone, propylene sulfite and tetrahydrofuran. Particularly, in the carbonate-based organic solvent, cyclic carbonate such as ethylene carbonate and propylene carbonate is a high-viscosity organic solvent and contributes to the dissociation of the lithium salt in the electrolyte due to a high dielectric constant, and when low-viscosity, low-permittivity linear carbonate such as dimethyl carbonate and diethyl carbonate is mixed with cyclic carbonate in an appropriate ratio, more preferably the electrolyte solution may have a high electrical conductivity.

Optionally, the electrolyte solution stored according to the present disclosure may further comprise an additive commonly used in electrolyte solutions, for example, an overcharge inhibitor.

The battery case used in the present disclosure may include those commonly used in the art, and is not limited to a particular shape according to the purpose of use of the battery and may include, for example, cylindrical, prismatic, pouch or coin shape using a can.

Hereinafter, the present disclosure will be described in detail through test examples and examples to help understanding of the present disclosure. However, the examples according to the present disclosure may be modified in many other forms, and the scope of the present disclosure should not be construed as being limited to the following examples. The examples of the present disclosure are provided to help those having ordinary skill in the art to understand the present disclosure fully and completely.

Comparative Example 1

$LiNi_{0.8}Mn_{0.1}Co_{0.1}O_2$ as a positive electrode active material, carbon black (product name: Denka Black) as a conductive material, and polyvinylidene fluoride (PVdF) (product name: KF1300) as a binder polymer are added to N-methyl-2-pyrrolidone (NMP) as a solvent in a weight ratio of 97.5:1:1.5 to prepare a positive electrode slurry. The positive electrode slurry is coated on two surfaces of an aluminum current collector having a thickness of 12 $\mu$m and dried at 135°C for 3 hours, followed by pressing, to manufacture a positive electrode having a positive electrode active material layer of 90 $\mu$m in thickness and 25% porosity on each of the two surfaces of the current collector. The prepared positive electrode is used without a separate atomic layer deposition process.

Comparative Example 2

The positive electrode substrate manufactured in the same way as Comparative Example 1 is mounted on an atomic layer deposition system (Lucida C200-PL, NCDTech), and trimethyl aluminum ($Al(CH_3)_3$) as a metal precursor is injected into the system for 0.1 sec. The precursor is filled in a steel container maintained at 14°C, and the vaporized precursor is injected into the system without using a separate carrier gas. In this instance, the temperature inside the system is maintained at 120°C. Subsequently, after purging for 5 sec using Ar as an inert gas, water vapor filled in the steel container maintained at 11°C is supplied for 0.2 sec to substitute methyl groups of aluminum with OH groups. Subsequently, impurities and unreacted components in the system are removed by purging for another 10 sec using Ar as an inert gas. The atomic layer deposition process is performed repeatedly twice to manufacture a positive electrode having an aluminum oxide coating layer formed on the surface of the positive electrode active material layer to the thickness of about 0.2 nm.

Example 1

The atomic layer deposition process is performed in the same way as Comparative Example 2, but different in the injection time of the precursor, the reactive gas and the purge gas and the number of times of the atomic layer deposition process. The injection time of trimethylaluminum $(Al(CH_3)_3)$ is set to 0.5 sec, and after purging for 10 sec using Ar as an inert gas, water vapor is supplied for 1 sec to substitute the methyl groups of the aluminum with OH groups. Subsequently, impurities and unreacted components in the system are removed by purging for another 20 sec using Ar as an inert gas. The atomic layer deposition process is performed repeatedly 5 times to manufacture a positive electrode having an aluminum oxide coating layer formed on the surface of the positive electrode active material layer to the thickness of about 0.55 nm.

Example 2

The atomic layer deposition process is performed in the same way as Comparative Example 2, but different in the injection time of the precursor, the reactive gas and the purge gas and the number of times of the atomic layer deposition process. The injection time of trimethylaluminum $(Al(CH_3)_3)$ is set to 2 sec, and after purging for 50 sec using Ar as an inert gas, water vapor is supplied for 2 sec to substitute the methyl groups of the aluminum with OH groups. Subsequently, impurities and unreacted components in the system are removed by purging for another 50 sec using Ar as an inert gas. The atomic layer deposition process is performed repeatedly twice to manufacture a positive electrode having an aluminum oxide coating layer formed on the surface of the positive electrode active material layer to the thickness of about 0.24 nm.

Example 3

The atomic layer deposition process is performed in the same way as Comparative Example 2, but different in the injection time of the precursor, the reactive gas and the purge gas and the number of times of the atomic layer deposition process. The injection time of trimethylaluminum $(Al(CH_3)_3)$ is set to 2 sec, and after purging for 50 sec using Ar as an inert gas, water vapor is supplied for 2 sec to substitute the methyl groups of the aluminum with OH groups. Subsequently, impurities and unreacted components in the system are removed by purging for another 50 sec using Ar as an inert gas. The atomic layer deposition process is performed repeatedly 7 times to manufacture a positive electrode having an aluminum oxide coating layer formed on the surface of the positive electrode active material layer to the thickness of about 0.84 nm.

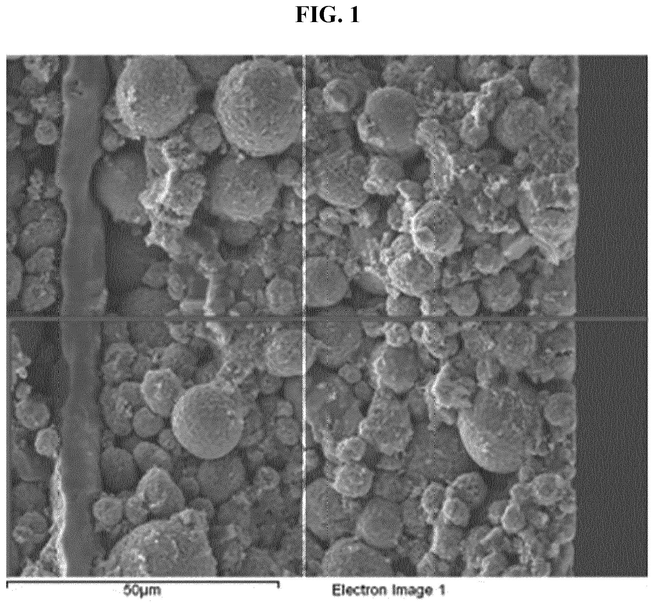

A cross-sectional electron micrographic image of the positive electrode having the prepared atomic layer deposition coating layer and an elemental mapping image of aluminum measured through Energy Dispersive X-ray Spectroscopy are shown in FIGS. 1 and 2, respectively.

The surface of the positive electrode active material layer (the uppermost positive electrode active material layer portion) of the positive electrode is positioned in the vertical direction on the right side of FIG. 1, and the current collector is positioned in the vertical direction on the left side of FIG. 1. FIG. 2 is an elemental mapping image of aluminum measured through Energy Dispersive X-ray Spectroscopy of the lower part shown in FIG. 1. Referring to FIG. 2, Al is observed in the vertical left area corresponding to the aluminum current collector of FIG. 1, and regions of the same color distributed in the active material layer are observed and they are the atomic layer deposition coating layer.

Comparative Example 3

The atomic layer deposition process is performed in the same way as Comparative Example 2, but different in the injection time of the precursor, the reactive gas and the purge gas and the number of times of the atomic layer deposition process. The injection time of trimethylaluminum $(Al(CH_3)_3)$ is set to 1 sec, and after purging for 50 sec using Ar as an inert gas, water vapor is supplied for 1 sec to substitute the methyl groups of the aluminum with OH groups. Subsequently, impurities and unreacted components in the system are removed by purging for another 50 sec using Ar as an inert gas. The atomic layer deposition process is performed repeatedly 10 times to manufacture a positive electrode having an $Al_2O_3$ coating layer formed on the surface of the positive electrode active material layer to the thickness of about 1.2 nm.

Experimental Example 1: Measurement of thickness of atomic layer deposition coating layer

The thickness of the atomic layer deposition coating layer disposed in the surface and the pores of the positive electrode active material layer is defined as a thickness formed by atomic layer deposition performed on a silicon wafer under the same condition as atomic layer deposition performed on the positive electrode active material layer, and the thickness may be measured by fitting psi and delta measurements at 380 nm to 780 nm using a Spectroscopic ellipsometer using a Modified Cauchy model.

To determine the deposition rate (growth per cycle) under the atomic layer deposition coating conditions corresponding to Comparative Examples and Examples, the thickness measured using the ellipsometer by repeating the atomic layer deposition process 200 times under the atomic layer deposition conditions corresponding to each Comparative Example and Example and the coating thickness per cycle of atomic layer deposition calculated therefrom are shown in Table 1 below.

[Table 1]

| Process conditions | | | | | Thickness measured by Ellipsometer (nm) | Deposition rate (GPC) (nm/cycle) |
|---|---|---|---|---|---|---|
| TMA Injection time (sec) | Ar purge time (sec) | Water Vapor supply time (sec) | Ar purge time (sec) | Number of cycles of ALD process (times) | | |
| 0.1 | 5 | 0.2 | 10 | 200 | 20.2 | 0.101 |
| 0.5 | 10 | 1 | 20 | 200 | 21.8 | 0.109 |
| 2 | 50 | 2 | 50 | 200 | 24.4 | 0.122 |

The thickness of the positive electrode active material layer in the positive electrodes manufactured in Examples 1 to 3 and Comparative Examples 1 to 3 is calculated by the above method, and the results are shown in Table 2.

Experimental Example 2: Distribution uniformity of atomic layer deposition coating layer

In the positive electrodes manufactured in Examples 1 to 3 and Comparative Examples 1 to 3, when the positive electrode active material layer is equally divided into five in the thickness-wise direction, and among the five equal divisions, the positive electrode active material layer portion in contact with the current collector is referred to as a lowermost positive electrode active material layer, and the surface portion of the positive electrode active material layer farthest away from the current collector is referred to as an uppermost positive electrode active material layer, an amount of the atomic layer deposition coating layer of the lowermost positive electrode active material layer and an amount of the atomic layer deposition coating layer of the uppermost positive electrode active material layer are measured using an electron microscope (FE-SEM, JEOL JSM-7200F) by an energy dispersive X-ray Spectroscopy (Oxford EXTREME EDS system) under the condition of the acceleration voltage of 15 kV and the working distance of 15 mm.

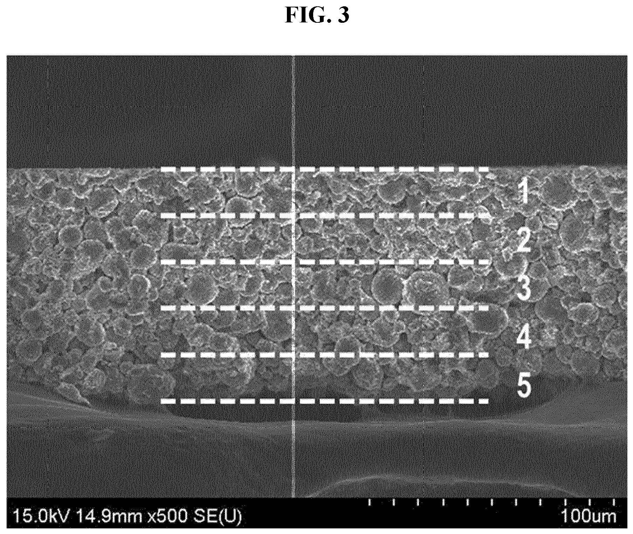

When the positive electrode active material layer is referred to as a first positive electrode active material layer, a second positive electrode active material layer, a third positive electrode active material layer, a fourth positive electrode active material layer and a fifth positive electrode active material layer in an order of from the surface portion of the positive electrode active material layer farthest away from the current collector to the positive electrode active material layer portion in contact with the current collector, the first positive electrode active material layer may correspond to the uppermost positive electrode active material layer, and the fifth positive electrode active material layer may correspond to the lowermost positive electrode active material layer. The cross-sectional electron micrographic image of the positive electrode active material layer partitioned into the first positive electrode active material layer to the fifth positive electrode active material layer is shown in FIG. 3.

Subsequently, the distribution uniformity of the atomic layer deposition coating layer is calculated as a ratio of the amount of the atomic layer deposition coating layer of the lowermost positive electrode active material layer to the amount of the atomic layer deposition coating layer of the uppermost positive electrode active material layer, and is shown in the following Table 2.

Experimental Example 3: Measurement of porosity (%) of positive electrode

The porosity of the positive electrodes of Examples 1 to 3 and Comparative Examples 1 to 3 is measured by the following method and the measurements are shown in Table 2 below.

(1) The thickness and weight per unit area of the positive electrode are measured.
(2) The density of the positive electrode (the positive electrode active material layer) including the pores is calculated by dividing the measured weight per unit area by the volume obtained by multiplying the measured thickness by the unit area.
(3) The theoretical density is calculated by multiplying the distribution amount per unit area of the constituent components of the positive electrode (the positive electrode active material, the conductive material, the binder polymer, and in the case of atomic layer deposition, the atomic layer deposition coating layer) by each known true density value.

(4) The porosity is calculated by the following equation.

Porosity (%) = [(Theoretical density calculated from (3))/(Measured density calculated from (2))-1] X 100

Experimental Example 4: Charge/discharge test (Capacity retention)

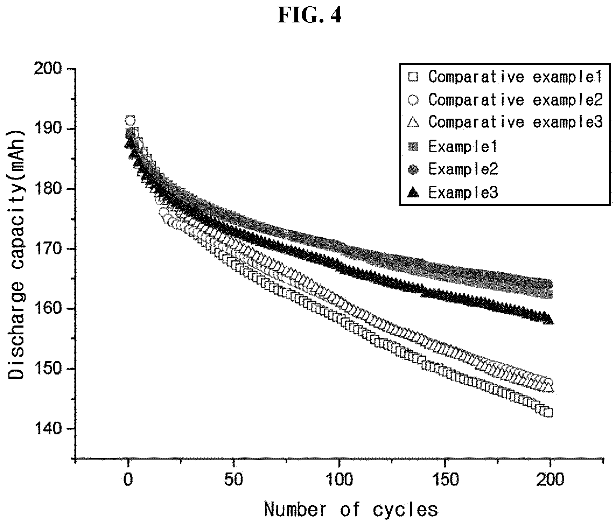

For a charge/discharge test, a monocell is manufactured using the positive electrode manufactured in Examples and Comparative Examples, a negative electrode comprising graphite, a conductive material and a binder, a polypropylene separator interposed between the positive electrode and the negative electrode, and an ethylenecarbonate/dimethylcarbonate/LiPF$_6$ (Merck Battery Grade, EC/DMC (volume ratio) = 1/1, 1M LiPF$_6$) organic electrolyte solution. The monocell is activated, and then charged/discharged in the condition of 45°C. The charging is performed with the current density of 0.3C rate up to 4.25V, and discharging is performed with the same current density down to 2.5V. The charging/discharging is performed for 200 cycles, and the capacity is measured every 100 cycle. The capacity cycle results during charging/discharging are shown in FIG. 4, and the capacity retention in 200 charge/discharg cycles is shown in the following Table 2.

Experimental Example 5: Storage stability evaluation

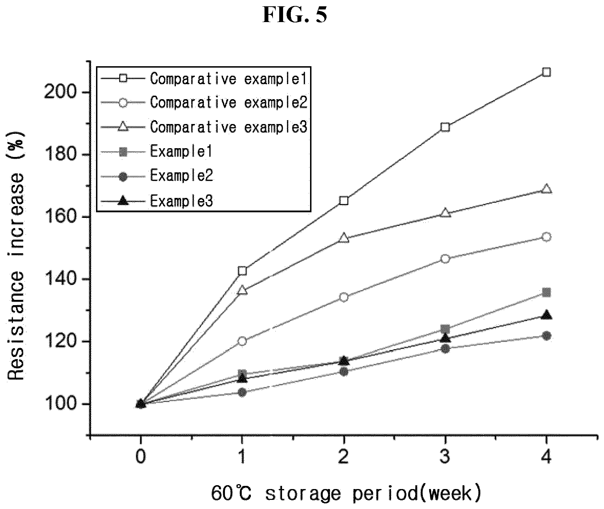

To evaluate storage stability, the monocell manufactured in Experimental Example 1 is activated, the initial resistance (Direct Current Internal Resistance (DCIR)) is measured at 4.25V in 100% fully charged state, and subsequently, DCIR is measured every week for 4 weeks during storage at 60°C. The storage stability of the monocell is evaluated as a ratio (%) of 4th week resistance to initial resistance and shown in the following Table 2. A resistance increase (%) of resistance of from 1st to 4th weeks to initial resistance, i.e., a resistance increase (%) graph for 60°C storage period (weeks) is shown in FIG. 5.

[Table 2]

| | Process condition | | | | | Positive electrode | | | Battery performance | |
|---|---|---|---|---|---|---|---|---|---|---|
| | TMA injection time (sec) | Ar purging time (sec) | Water vapor supply time (sec) | Ar purging time (sec) | ALD process cycle number (times) | Deposition thickness on the basis of flat plate (nm) | Distribution uniformity of ALD coating layer (%) | Porosity of positive electrode active material layer (%) | Capacity retention before and after 200 cycle charge/discharge (%) | Storage stability (Resistance increase of 4th week resistance to initial resistance (%)) |
| Comparative Example 1 | - | - | - | - | - | - | - | 25 | 74.4 | 207 |
| Comparative Example 2 | 0.1 | 5 | 0.2 | 10 | 2 | 0.2 | 6 | 25 | 77.1 | 154 |
| Example 1 | 0.5 | 10 | 1 | 20 | 5 | 0.55 | 49 | 25 | 85.7 | 136 |
| Example 2 | 2 | 50 | 2 | 50 | 2 | 0.24 | 81 | 25 | 86.8 | 122 |
| Example 3 | 2 | 50 | 2 | 50 | 7 | 0.84 | 107 | 25 | 84.1 | 128 |
| Comparative Example 3 | 1 | 50 | 1 | 50 | 10 | 1.2 | 99 | 25 | 78.3 | 169 |

Referring to Table 2, compared to Comparative Examples 1 to 3, the positive electrodes of Examples 1 to 3 satisfying both the thickness range and the distribution uniformity range of the atomic layer deposition coating layer according to the present disclosure exhibit high capacity retention in 200 cycles and long life characteristics, and remarkably high storage stability since a battery resistance increase is not large even after long-term storage.

## Claims

1.  A positive electrode for a lithium secondary battery, comprising:

    a current collector; and
    a positive electrode active material layer comprising a plurality of positive electrode active materials disposed at least one surface of the current collector and an atomic layer deposition coating layer disposed in surfaces and pores of the positive electrode active materials and gaps between the plurality of positive electrode active materials, wherein the positive electrode active materials include a lithium cobalt-nickel-manganese oxide, and the atomic layer deposition coating layer comprises $AlO_x$, wherein x is greater than 0 and 3 or smaller,
    wherein the atomic layer deposition coating layer is 0.2 to 1 nm in thickness,
    when the positive electrode active material layer is equally divided into five layers in a thickness-wise direction, the portion of the positive electrode active material layer in contact with the current collector is referred to as the lowermost positive electrode active material layer and the surface portion of the positive electrode active material layer farthest away from the current collector is referred to as the uppermost positive electrode active material layer, the amount of the atomic layer deposition coating layer of the lowermost positive electrode active material layer is 40 weight% or more relative to the amount of the atomic layer deposition coating layer of the uppermost positive electrode active material layer, and
    the positive electrode has a porosity of 15% to 35%,
    wherein the positive electrode is obtainable by forming an atomic layer deposition coating layer on the pressed positive electrode.

2.  The positive electrode for a lithium secondary battery according to claim 1, wherein the porosity of the positive electrode is 20 to 30%.

3.  The positive electrode for a lithium secondary battery according to claim 1, wherein the atomic layer deposition coating layer is 0.2 to 0.8 nm in thickness.

4.  The positive electrode for a lithium secondary battery according to claim 1, wherein the amount of the atomic layer deposition coating layer of the lowermost positive electrode active material layer is 40 weight% to 120 weight% relative to the amount of the atomic layer deposition coating layer of the uppermost positive electrode active material layer.

5.  The positive electrode for a lithium secondary battery according to claim 1, wherein the amount of the atomic layer deposition coating layer is 300 ppm to 6,000 ppm based on the total weight of the positive electrode active material layer.

6.  A lithium secondary battery comprising:

    an electrode assembly comprising a positive electrode, a negative electrode and a separator interposed between the positive electrode and the negative electrode; a battery case in which the electrode assembly is received; and a non-aqueous electrolyte solution injected into the battery case,
    wherein the positive electrode is the positive electrode for a lithium secondary battery according to any one of claims 1 to 8.

7.  A method for manufacturing a positive electrode according to any one of claims 1 to 6, comprising:

    Step (1) of preparing a positive electrode active material layer composition containing a positive electrode active material, a binder polymer, a conductive material and a solvent,
    Step (2) of applying the positive electrode active material layer composition on at least one surface of a current collector,
    Step (3) of drying and pressing through a roll press to form a positive electrode active material layer, and
    Step (4) of forming an atomic layer deposition coating layer in the surface and pores of the positive electrode active material layer.

8. The method according to claim 7, wherein Step (4) includes:

mounting a positive electrode substrate, which is a current collector having the positive electrode active material layer obtained in Step (3) on an atomic layer deposition system,
injecting a metal precursor into the system,
purging using an inert gas,
supplying water vapor to substitute the binding groups of the metal precursor with OH groups, and
purging using an inert gas to remove impurities and unreacted components from the system to form an atomic layer deposition coating layer.

9. The method according to claim 8, wherein Step (4) is performed at a heating temperature of the positive electrode substrate of 120°C to 150°C.

10. The method according to claim 8 or 9, wherein in Step (4), the metal precursor includes trimethylaluminum.

**Patentansprüche**

1. Positive Elektrode für eine Lithium-Sekundärbatterie, umfassend:

einen Stromabnehmer; und
eine Positivelektroden-Aktivmaterialschicht, umfassend eine Vielzahl von Positivelektroden-Aktivmaterialien, angeordnet auf zumindest einer Oberfläche des Stromabnehmers, und eine Atomschichtabscheidungs-Beschichtungsschicht, angeordnet auf Oberflächen und in Poren der Positivelektroden-Aktivmaterialien und Lücken zwischen der Vielzahl von Positivelektroden-Aktivmaterialien, worin die Positivelektroden-Aktivmaterialien ein Lithium-Kobalt-Nickel-Mangan-Oxid umfassen und die Atomschichtabscheidungs-Beschichtungsschicht $AlO_x$ umfasst, worin x größer als 0 und 3 oder kleiner ist,
worin die Atomschichtabscheidungs-Beschichtungsschicht eine Dicke von 0,2 bis 1 nm aufweist,
worin, wenn die Positivelektroden-Aktivmaterialschicht gleichmäßig in fünf Schichten in Dickenrichtung aufgeteilt wird,
der Teil der Positivelektroden-Aktivmaterialschicht in Kontakt mit dem Stromabnehmer als unterste Positivelektroden-Aktivmaterialschicht bezeichnet wird und der Oberflächenbereich der Positivelektroden-Aktivmaterialschicht, die sich am weitesten weg von dem Stromabnehmer befindet, als oberste Positivelektroden-Aktivmaterialschicht bezeichnet wird,
die Menge der Atomschichtabscheidungs-Beschichtungsschicht der untersten Positivelektroden-Aktivmaterialschicht 40 Gew.-% oder mehr beträgt, relativ zur Menge der Atomschichtabscheidungs-Beschichtungsschicht der obersten Positivelektroden-Aktivmaterialschicht, und
worin die positive Elektrode eine Porosität von 15 % bis 35 % aufweist,
worin die positive Elektrode erhältlich ist durch Bilden einer Atomschichtabscheidungs-Beschichtungsschicht auf der gepressten positiven Elektrode.

2. Positive Elektrode für eine Lithium-Sekundärbatterie gemäß Anspruch 1, worin die Porosität der positiven Elektrode 20 bis 30 % beträgt.

3. Positive Elektrode für eine Lithium-Sekundärbatterie gemäß Anspruch 1, worin die Atomschichtabscheidungs-Beschichtungsschicht eine Dicke von 0,2 bis 0,8 nm aufweist.

4. Positive Elektrode für eine Lithium-Sekundärbatterie gemäß Anspruch 1, worin die Menge der Atomschichtabscheidungs-Beschichtungsschicht der untersten Positivelektroden-Aktivmaterialschicht 40 Gew.-% bis 120 Gew.-% beträgt, relativ zur Menge der Atomschichtabscheidungs-Beschichtungsschicht der obersten Positivelektroden-Aktivmaterialschicht.

5. Positive Elektrode für eine Lithium-Sekundärbatterie gemäß Anspruch 1, worin die Menge der Atomschichtabscheidungs-Beschichtungsschicht 300 ppm bis 6.000 ppm beträgt, bezogen auf das Gesamtgewicht der Positivelektroden-Aktivmaterialschicht.

**6.** Lithium-Sekundärbatterie, umfassend:

eine Elektrodenanordnung, umfassend eine positive Elektrode, eine negative Elektrode und einen zwischen der positiven Elektrode und der negativen Elektrode vorgesehenen Separator; ein Batteriegehäuse, in das die Elektrodenanordnung aufgenommen ist; und eine nichtwässrige Elektrolytlösung, die in das Batteriegehäuse eingebracht ist,
worin die positive Elektrode die positive Elektrode für eine Lithium-Sekundärbatterie gemäß irgendeinem der Ansprüche 1 bis 8 ist.

**7.** Verfahren zur Herstellung einer positiven Elektrode gemäß irgendeinem der Ansprüche 1 bis 6, umfassend:

einen Schritt (1) zum Bilden einer Positivelektroden-Aktivmaterialschichtzusammensetzung, die ein Positivelektroden-Aktivmaterial, ein Binderpolymer, ein leitfähiges Material und ein Lösungsmittel enthält,
einen Schritt (2) zum Auftragen der Positivelektroden-Aktivmaterialschichtzusammensetzung auf zumindest eine Oberfläche eines Stromabnehmers,
einen Schritt (3) zum Trocknen und Pressen durch eine Presswalze, um eine Positivelektroden-Aktivmaterialschicht zu bilden, und
einen Schritt (4) zum Bilden einer Atomschichtabscheidungs-Beschichtungsschicht auf der Oberfläche und in den Poren der Positivelektroden-Aktivmaterialschicht.

**8.** Verfahren gemäß Anspruch 7, worin der Schritt (4) umfasst:

Montieren eines Positivelektroden-Substrats, welches ein Stromabnehmer mit der Positivelektroden-Aktivmaterialschicht ist, der in Schritt (3) erhalten wurde, auf einem Atomschichtabscheidungssystem,
Einbringen eines Metall-Vorläufers in das System,
Spülen unter Verwendung eines Inertgases,
Zuführen von Wasserdampf, um die Bindungsgruppen des Metall-Vorläufers durch OH-Gruppen zu ersetzen, und
Spülen unter Verwendung eines Inertgases, um Verunreinigungen und unreagierte Komponenten aus dem System zu entfernen, um eine Atomschichtabscheidungs-Beschichtungsschicht zu bilden.

**9.** Verfahren gemäß Anspruch 8, worin der Schritt (4) bei einer Erwärmungstemperatur des Positivelektroden-Substrats von 120°C bis 150°C durchgeführt wird.

**10.** Verfahren gemäß Anspruch 8 oder 9, worin im Schritt (4) der Metall-Vorläufer Trimethylaluminium umfasst.


**Revendications**

**1.** Électrode positive pour batterie secondaire au lithium, comprenant :

un collecteur de courant ; et
une couche de matériau actif d'électrode positive comprenant une pluralité de matériaux actifs d'électrode positive disposés sur au moins une surface du collecteur de courant et une couche de revêtement par dépôt de couche atomique disposée sur les surfaces et dans les pores des matériaux actifs d'électrode positive et dans les espaces entre la pluralité de matériaux actifs d'électrode positive, dans laquelle les matériaux actifs d'électrode positive comprennent un oxyde de lithium, de cobalt, de nickel et de manganèse, et la couche de revêtement par dépôt de couche atomique comprend de l'$AlO_x$, où x est supérieur à 0 et inférieur ou égal à 3, la couche de revêtement par dépôt de couche atomique ayant une épaisseur de 0,2 à 1 nm,
lorsque la couche de matériau actif d'électrode positive est divisée en cinq couches égales dans le sens de l'épaisseur, la partie de la couche de matériau actif d'électrode positive en contact avec le collecteur de courant est appelée couche de matériau actif d'électrode positive la plus basse et la partie de surface de la couche de matériau actif d'électrode positive la plus éloignée du collecteur de courant est appelée couche de matériau actif d'électrode positive la plus haute, la quantité de la couche de revêtement par dépôt de couche atomique de la couche de matériau actif d'électrode positive la plus basse est de 40 % en poids ou plus par rapport à la quantité de la couche de revêtement par dépôt de couche atomique de la couche de matériau actif d'électrode positive la plus haute, et
l'électrode positive a une porosité de 15 % à 35 %,

dans laquelle l'électrode positive peut être obtenue en formant une couche de revêtement par dépôt de couche atomique sur l'électrode positive pressée.

2. L'électrode positive pour batterie secondaire au lithium selon la revendication 1, dans laquelle la porosité de l'électrode positive est de 20 à 30 %.

3. L'électrode positive pour batterie secondaire au lithium selon la revendication 1, dans laquelle la couche de revêtement par dépôt de couche atomique a une épaisseur de 0,2 à 0,8 nm.

4. L'électrode positive pour une batterie secondaire au lithium selon la revendication 1, dans laquelle la quantité de la couche de revêtement par dépôt de couche atomique de la couche de matériau actif d'électrode positive la plus basse est de 40 % à 120 % en poids par rapport à la quantité de la couche de revêtement par dépôt de couche atomique de la couche de matériau actif d'électrode positive la plus haute.

5. L'électrode positive pour batterie secondaire au lithium selon la revendication 1, dans laquelle la quantité de la couche de revêtement par dépôt de couche atomique est de 300 ppm à 6 000 ppm par rapport au poids total de la couche de matériau actif de l'électrode positive.

6. Batterie secondaire au lithium comprenant :

    un ensemble d'électrodes comprenant une électrode positive, une électrode négative et un séparateur interposé entre l'électrode positive et l'électrode négative ; un boîtier de batterie dans lequel est logé l'ensemble d'électrodes ; et une solution électrolytique non aqueuse injectée dans le boîtier de batterie,
    dans laquelle l'électrode positive est l'électrode positive pour une batterie secondaire au lithium selon l'une quelconque des revendications 1 à 8.

7. Procédé de fabrication d'une électrode positive selon l'une quelconque des revendications 1 à 6, comprenant :

    l'étape (1) consistant à préparer une composition de couche de matériau actif d'électrode positive contenant un matériau actif d'électrode positive, un polymère liant, un matériau conducteur et un solvant,
    l'étape (2) consistant à appliquer la composition de couche de matériau actif d'électrode positive sur au moins une surface d'un collecteur de courant,
    l'étape (3) consistant à sécher et à presser à l'aide d'une presse à rouleaux pour former une couche de matériau actif d'électrode positive, et
    l'étape (4) consistant à former une couche de revêtement par dépôt de couche atomique à la surface et dans les pores de la couche de matériau actif d'électrode positive.

8. Le procédé selon la revendication 7, dans lequel l'étape (4) comprend :

    le montage d'un substrat d'électrode positive, qui est un collecteur de courant comportant la couche de matériau actif d'électrode positive obtenue à l'étape (3), sur un système de dépôt par couche atomique, l'injection d'un précurseur métallique dans le système, la purge à l'aide d'un gaz inerte,
    l'apport de vapeur d'eau pour substituer les groupes de liaison du précurseur métallique par des groupes OH, et la purge à l'aide d'un gaz inerte pour éliminer les impuretés et les composants n'ayant pas réagi du système afin de former une couche de revêtement par dépôt de couche atomique.

9. Le procédé selon la revendication 8, dans lequel l'étape (4) est réalisée à une température de chauffage du substrat d'électrode positive de 120 °C à 150 °C.

10. Le procédé selon la revendication 8 ou 9, dans lequel, à l'étape (4), le précurseur métallique comprend du triméthylaluminium.

**FIG. 1**

50µm     Electron Image 1

FIG. 2

Al Ka1

**FIG. 3**

FIG. 4

FIG. 5

**EP 3 955 335 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020190064862
- US 20120077082 A1
- US 20180108908 A1
- US 20160172682 A1